# EUROPEAN PATENT APPLICATION

(11) **EP 2 408 282 A1**
(43) Date of publication of application: **18.01.2012**
(21) Application number: 11005260.2
(22) Date of filing: 28.06.2011
(51) Int. Cl.: H05K 1/18

(54) **Module connection in a printed wiring board**

(30) Priority: 12.07.2010 US 834062
(71) Applicant: Sony Ericsson Mobile Communications AB, 221 88 Lund (SE)
(72) Inventor: Demuynck, Randolph Cary, Wake Forest, NC 27587 (US); Story, David Ryan, Holly Springs, NC 27540 (US)
(74) Representative: Banzer, Hans-Jörg

(57) **Abstract**

An electronic device has a housing and circuitry disposed within the housing. The circuitry is mounted to, for example, a top surface (18) of a Printed Wiring Board (PWB) (10) disposed within the housing. The PWB has a dual-height cavity (30) that is formed as a recess in the top surface (18). The dual-height cavity (30) is sized to receive one or more electronic components (50). Electrical contacts (38, 40) disposed within the dual-height cavity (30) electrically connect the electronic component (50) to electronic circuits mounted to the top surface (18) of the PWB (10).

## Description

The present invention relates generally to Printed Wiring Boards (PWBs) and more specifically to PWBs having dual-height stepped cavities.

Engineers face many challenges when designing electronic devices. One particularly difficult problem is how to develop electronic devices that are small and flexible without negatively impacting functionality. For example, many mobile communication device designers consistently try to design cellular telephones that are smaller than previous devices. The resulting designs, however, must retain the ability to accommodate functionality that consumers currently enjoy. Further, in at least some cases, the designs must also be able to support new functionality.

Although difficult, striving to design and create smaller devices can be beneficial. For example, the technologies developed to create small electronic devices can also be used to create larger ones. With these larger devices, designers and engineers can include additional more complex components that provide increased functionality for the user. However, these same efforts can often yield a "one-of-a-kind" product. That is, although the technologies learned while designing and creating small devices can be applied to larger devices, the actual components are not as easily re-used.

Further, designing and creating flexible solutions can often result in a size penalty. For example, some manufacturers use a modular approach to designing electronic devices in which different functions are modularized and added to a device. Thus, to add a transceiver function to a cellular telephone, a corresponding transceiver module containing all or most of the circuitry required for its operation is affixed to the surface of a Printed Wiring Board (PWB) or Printed Circuit Board (PCB). The PWB/PCD is then placed into a housing of a cellular telephone.

Modular approaches are beneficial because they minimize the number of individual components one must connect to the surface of a PWB/PCB. However, because the modules mount to the PWB/PCB surface, the overall size of the device can end up being larger than if the module had been split-up into its constituent components and mounted directly to the surface of the PWB/PCB.

### SUMMARY

According to the invention, a Printed Wiring Board (PWB) as defined in claim 1, a method as defined in claim 12, and a wireless communication device as defined in claim 15 are provided. The dependent claims define preferred or advantageous embodiments of the invention.

The present invention provides a Printed Wiring Board (PWB) that receives one or more electronic components formed as modules into a recess or cavity formed in a surface of the PWB. As those persons having ordinary skill in the art will readily appreciate, a "Printed Wiring Board (PWB)" is also referred to as a "Printed Circuit Board (PCB)." Therefore, as used herein, the terms are interchangeable and used to mean the same thing.

In one embodiment, the PWB comprises a generally planar top surface configured to receive electronic circuit components, and a dual-height cavity formed in the top surface of the PWB. The dual-height cavity is sized to receive a first electronic component, and comprises a sidewall and a floor surface, a step formed within the dual-height cavity and along the sidewall, and an electrical connection formed within the dual-height cavity. The electrical connection is configured to electrically connect the first electronic component mounted within the cavity to one or more of the electronic components mounted on the top surface.

In one embodiment, the electrical connection comprises an array of conductive pads formed on a surface of the step.

In one embodiment, the electrical connection comprises a conductive adhesive disposed on a surface of the step.

In one embodiment, the electrical connection comprises a connector disposed on a surface of the step.

In one embodiment, the electrical connection comprises a conductive pathway extending through the interior of the PWB to the one or more electronic components mounted on the top surface.

In one embodiment, a top surface of the first electronic component lies generally within the same plane as the top surface of the PWB when the first component is mounted to the step within the dual-height cavity.

In one embodiment, a gap is formed between the first electronic component and the floor surface when the first component is mounted to the step within the dual-height cavity.

In one embodiment, the electrical connection comprises a connector disposed on the floor surface of the dual-height cavity within the gap.

In one embodiment, the electrical connection comprises a first electrical connection formed on a surface of the step. In such embodiments, the PWB may further comprise a second electrical connection disposed on the floor surface of the dual-height cavity.

In one embodiment, the second electrical connection is configured to electrically connect a second electronic component mounted within the dual-height cavity to the PWB.

In one embodiment, the step has a height that is between the top surface of the PWB and the floor surface of the dual-height cavity.

Additionally, embodiments of the present invention also provide a method of mounting electronic components to a Printed Wiring Board (PWB) having a top surface for mounting electronic components. In one embodiment, the method comprises mounting a first electronic component within a dual-height stepped cavity formed in the top surface of the PWB, and electrically connecting the first electronic component to the PWB via a first electrical contact disposed within the dual-height cavity.

In one embodiment, electrically connecting the first electronic component to the PWB comprises electrically connecting the first electronic component to one or more electronic components mounted on the top surface of the PWB via a first conductive path extending through the interior of the PWB between the first electrical contact and the top surface of the PWB.

In one embodiment, the method further comprises electrically connecting a second electronic component to the PWB via a second electrical contact disposed within the dual-height cavity.

In one embodiment, electrically connecting the second electronic component to the PWB comprises electrically connecting the second electronic component to the one or more electronic components mounted on the top surface of the PWB via a second conductive path extending through the interior of the PWB between the second electrical contact and the top surface of the PWB.

In one embodiment, the present invention also provides a wireless communication device comprising a housing, a transceiver module to communicate wireless signals to, and receive wireless signals from, a base station in a wireless communication network, and a Printed Wiring Board (PWB) disposed within the housing. In one embodiment, the PWB comprises a generally planar top surface configured to receive electronic circuit components, and a dual-height cavity formed in the top surface of the PWB and sized to receive a first electronic component. The dual-height cavity may comprise a sidewall and a floor surface, a step formed within the dual-height cavity and along the sidewall, and an electrical connection formed within the dual-height cavity. In one embodiment, the electrical connection is configured to electrically connect the first electronic component to one or more of the electronic components mounted on the top surface.

In one embodiment, the electrical contact is disposed on the step.

In one embodiment, the electrical contact is disposed on the floor surface.

In one embodiment, the electrical contact comprises a first electrical contact disposed on the step. In such embodiments, the dual-height cavity may further be sized to receive a second electronic component. Additionally, a second electrical contact may be disposed on the floor surface of the cavity to electrically connect the second electronic component to one or more other electronic components mounted to the PWB.

In one embodiment, the first electronic component comprises the transceiver module.

Of course, those skilled in the art will appreciate that the present invention is not limited to the above contexts or examples, and will recognize additional features and advantages upon reading the following detailed description and upon viewing the accompanying drawings.

### BRIEF DESCRIPTION OF THE DRAWINGS

Figure 1 is a perspective view illustrating a Printed Wiring Board (PWB) suitable for use with one embodiment of the present invention.
Figure 2 is a perspective view illustrating an exemplary type of electronic device suitable for use with one embodiment of the present invention.
Figure 3 is a perspective view illustrating a portion of a PWB configured according to one embodiment of the present invention.
Figures 4A-4B are perspective views illustrating a portion of a PWB configured to connect an electronic component to the PWB according to one embodiment of the present invention.
Figures 5A-5B are perspective views illustrating a portion of a PWB configured to connect an electronic component to the PWB according to another embodiment of the present invention.
Figure 6 is a perspective view illustrating a portion of a PWB configured to connect an electronic component to the PWB according to one embodiment of the present invention.
Figure 7 is a perspective view illustrating a portion of a PWB configured to connect an electronic component to the PWB according to another embodiment of the present invention.
Figure 8 is a perspective view illustrating a portion of a PWB configured to connect a plurality of electronic components to the PWB according to another embodiment of the present invention.
Figure 9 is a block diagram illustrating some of the component parts of an electronic device configured to function according to one embodiment of the present invention.

### DETAILED DESCRIPTION

The present invention provides a Printed Wiring Board (PWB) for a consumer electronic device. The PWB has a dual-height, stepped cavity that is formed as a recess within a surface of the PWB. Conventionally, these cavities are formed in PWBs to accommodate the contour of some adjacent structure, such as the contour of another substrate or of an electronic component mounted to an adjacent substrate. The present invention, however, provides one or more electrical contacts directly within the dual-height, stepped cavity such that electronic components may be mounted within the dual-height cavity.

Particularly, the dual-height cavity is sized to receive one or more electronic components that provide the functionality of the electronic device. Such components may be, for example, a transceiver module that permits a user of a cellular telephone to communicate with remote parties via a wireless communication network. The dual-height cavity includes electrical connections, such as conductive pads, for example, that electrically connect the electronic components mounted within the cavity to other electronic components that may be mounted on a surface of the PWB.

A PWB configured according to the present invention provides benefits that conventional PWBs cannot. For example, PWBs configured according to the present invention allows portable device designers to develop smaller, more flexible devices. Particularly, the components and circuitry associated with a given function may be developed and provided as a self-contained module that connects to the cavity formed in the PWB. These modules are the mounted directly within the cavity such that the surface of the self-contained modules lies substantially flush with the surface of the PWB. Thus, there is no marked increase in the size of the PWB. Further, because the module lies within the cavity, there could be a decrease in the size of the PWB footprint. Additionally, because the cavities allow for modularized electronic components, designers are able to test each module more thoroughly before assembly and independently of other modules and the PWB. This allows designers to identify and correct faults more efficiently than if all components were assembled first and tested as a single integrated unit.

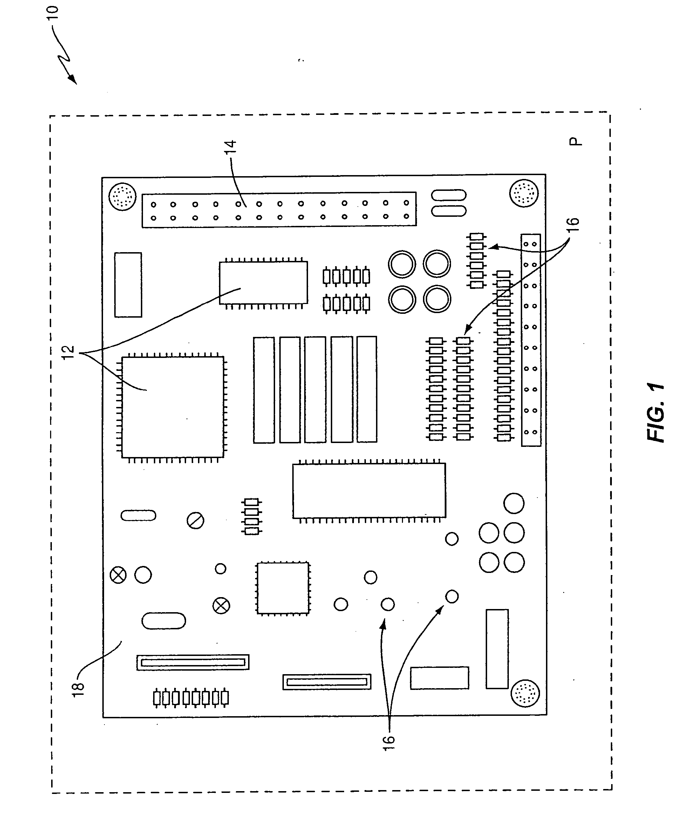

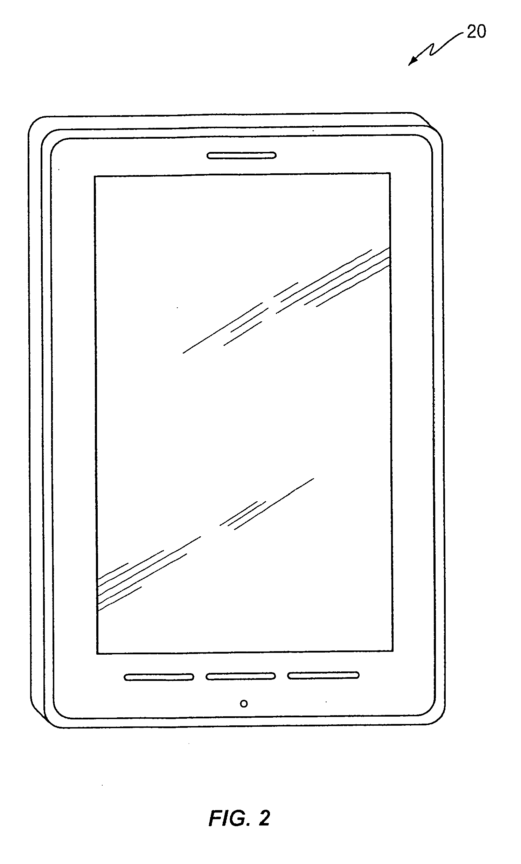

Turning now to the drawings, Figure 1 is a perspective view of a PWB assembly 10 configured according to one embodiment of the present invention, and Figure 2 illustrates a perspective view for one use of assembly 10. Particularly, assembly 10 may be utilized to support and electrically connect the components of a cellular telephone 20. However, its use in a cellular telephone 20 is merely for illustrative purposes. Those skilled in the art will readily appreciate that the assembly 10 is not limited for use in cellular telephones 20, but rather, may be utilized in any consumer electronic device regardless of size and function. Other types of electronic devices that may include the PWB assembly 10 include, but are not limited to, computing devices (e.g., tablet computing devices, desktops, laptops, notebooks, and servers), Portable Digital Assistants (PDAs), satellite communication devices, and other consumer electronic devices.

As seen in Figure 1, assembly 10 is used to support and electrically connect a plurality of electronic components 12, 14, and 16. Components 12, 14, 16 may comprise any electronic components known in the art. For example, the components 12, 14, 16 may be resistors, processing circuits, capacitors, connectors, diodes, sockets, switches, transducers, display devices, integrated circuits (ICs), heat sinks, and the like. Assembly 10 has a first surface 18 (e.g., a top surface) and an opposing second surface (e.g., a bottom surface - not shown), both of which extend generally parallel to a plane P. Components 12, 14, 16 may be mounted to one or both of the first and second surfaces, and depending on the particular design of the PWB, may also be sandwiched between the layers of substrate that comprise the PWB assembly 10.

Typically, assembly 10 uses conductive traces to electrically connect the components 12, 14, 16. As seen later in more detail, these traces usually extend along the surface(s) of the PWB assembly 10, but may also extend through the interior of the PWB assembly 10. There is a plurality of ways in which to manufacture the PWB and its traces. Generally, however, sheets of conductive material, such as copper for example, are laminated onto one or more layers of insulating dielectric materials that comprise the PWB substrate. Then, the unwanted portions of the copper are then removed using a process called "etching," which leaves only the desired conductive traces. In some cases, multiple PWBs may be bonded together after the etching process to form one or more conductive trace layers inside the PWB. Such PWBs are called multi-layer PWBs.

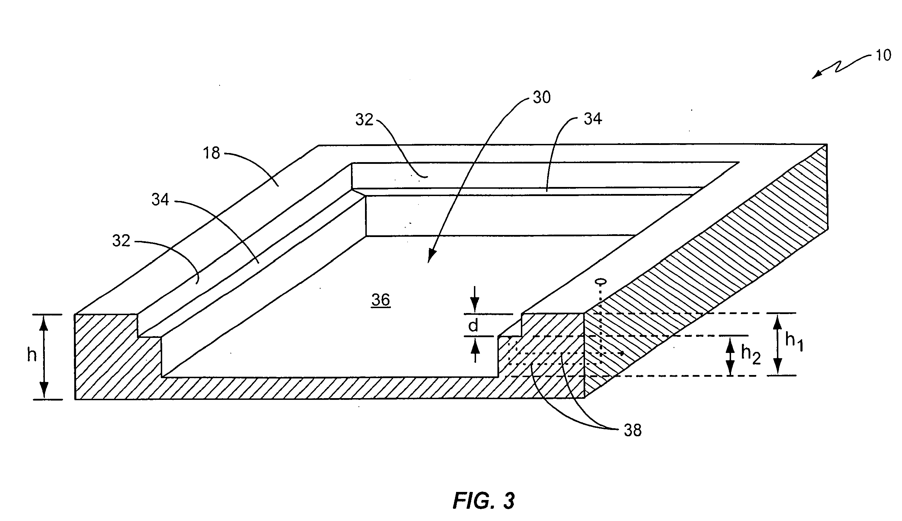

In one embodiment of the present invention, seen in Figure 3, the substrate portion of the PWB assembly 10 is formed to include an integral cavity 30 having a sidewall 32, a floor 36, and a step 34. One or more conductive traces 38 may, as described in more detail later, extend from one or more electrical connections disposed within the cavity 30 and through the substrate portion of the PWB assembly 10.

As seen in Figure 3, the cavity 30 is formed as a recess that extends into the surface 18 of the PWB substrate. The cavity 30 is sized to receive at least one electronic component, and in some cases, more than one electronic component. The components may be individual components, such as components 12, 14, 16, or, as seen later in more detail, a self-contained circuit module containing a plurality of individual components 12, 14, 16. When in a self-contained module, the components form circuitry that performs a certain function. For example, a module may be a transceiver module (e.g., a modem) containing the components needed for cellular telephone 20 to communicate wireless signals with a remote device via a wireless communications network. Other modules that perform other functions are also possible.

The sidewall 32 extends along the interior periphery of the cavity 30 and defines the sides of the cavity 30. Step 34 also extends around the interior of cavity 30 along the length of the sidewall 32. As seen later in more detail, the step 34 is used to support an electronic component disposed within the cavity 30. Additionally, although step 34 is formed from the substrate material of the assembly 10, one or more of the conductive traces 38 may extend from the step 34 to electrically connect the components within cavity 30 to other parts of the assembly 10. For example, the traces 38 may electrically connect one or more components disposed within the cavity 30 to one or more other components disposed on the surface 18 of the assembly.

The floor 36 is a generally flat part of the substrate interior that defines the bottom of the cavity 30. The floor 36 comprises a generally smooth surface that extends between the sides of the step 34. According to the present invention, the floor 36 need not contact an electronic component disposed within cavity 30. However, in at least one embodiment of the present invention, floor 36 is configured to receive and electrically connect an electronic component to the PWB assembly 10. In some embodiments, a connector or plug or similar type electrical connection may be disposed on the floor 36 to electrically connect a component to the PWB assembly 10. In such cases, the conductive traces 38 may extend from the floor 36 to other parts of the PWB assembly 10.

PWB substrates can have any desired thickness (i.e., height); however, in most cases, such substrates have a height *h* that is between about 0.8 - 1.2 mm. One or both of the heights *h₁*, *h₂* of the cavity 30 and step 34, respectively, may also be any height needed or desired. However, together, they are less than the total height *h* of the substrate. Further, the height *h₂* of the step 34 is selected such that the distance d between the step 34 and the top surface 18 of the assembly 10 substantially matches, or is greater than, a height of the electronic component to be disposed in the cavity 30. This allows the electronic component to seat within the cavity 30 such that its surface remains substantially flush with the surface 18 of the assembly 10.

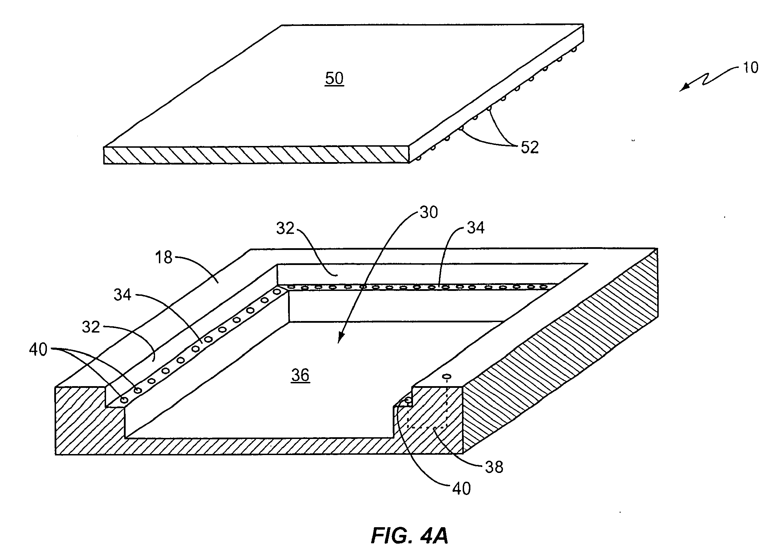

Figures 4A-4B illustrates one embodiment in which an electronic component is disposed within the cavity 30 of assembly 10. As previously stated, the cavity 30 may receive and electrically connect any of the components 12, 14, 16 individually. However, in this embodiment, cavity 30 is sized to receive and electrically connect a self-contained electronic module, such as module 50, to the assembly 10. Module 50 is an electronic component that typically includes electronic circuitry. The function of module 50 is not important to the invention, but for illustrative purposes only, module 50 in this embodiment comprises a transceiver for cellular telephone 20. That is, module 50 would include most, if not all, electronic components needed by cellular telephone 20 to communicate wireless signals with a remote party or other device via a wireless communication network.

As seen in Figure 4A, the step 34 is provided with a patterned array of conductive pads 40. The pads 40 may be comprised of copper or some other conductive metal or metal alloy, for example. Each pad in the array 40 has a corresponding conductive trace 38 that leads to a connection for some other component disposed on the PWB assembly 10. The module 50 also has an array 52 of solder balls disposed on its undersurface. The solder balls are formed in a pattern commonly referred to as a Ball Grid Array (BGA), which is a type of surface mount technology used to electrically connect components such as integrated circuits (ICs) to a substrate. In this embodiment, each solder ball in the array 52 corresponds to a particular conductive pad 40 disposed on a surface of step 34. To electrically connect the module 50 to the cavity 30, the module 50 is placed on step 34 such that each solder ball in array 52 is aligned with and contacts a corresponding conductive pad 40. The assembly 10 is then heated to cause the solder balls in the array 52 to melt to their respective conductive pads 40. Once the solder solidifies, the module is electrically connected to the cavity 30.

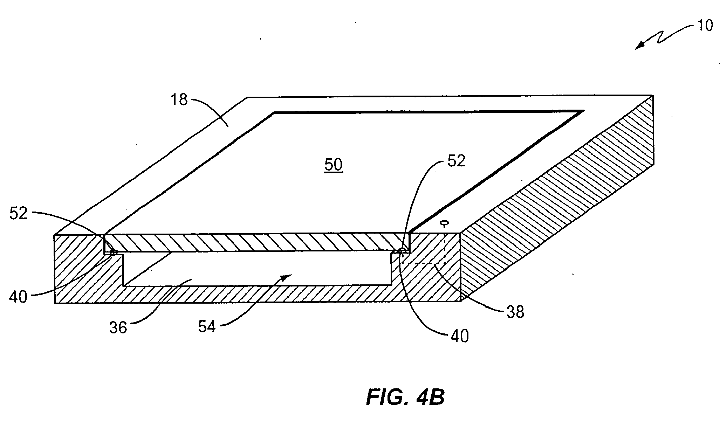

Figure 4B illustrates a perspective view of module 50 after it has been electrically connected to the cavity 30 of assembly 10. As seen in Figure 4B, the solder balls in the array 52 contact the pads 40 to make the electrical connections. The conductive traces 38 lead from each pad 40 to a conductive pad on the surface 18 to electrically connect the module 50 to another electronic component. Additionally, the top surface of module 50 is substantially flush with the top surface 18 of the PWB assembly 10. However, a gap 54 is formed between the bottom surface of the module 54 and the surface of floor 36.

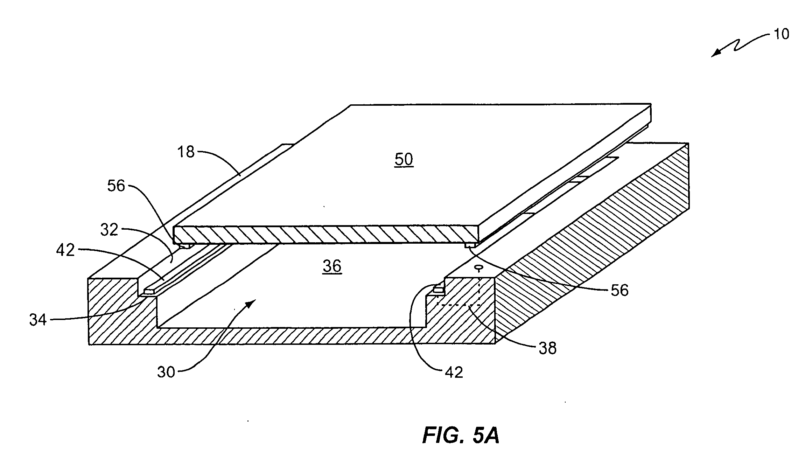

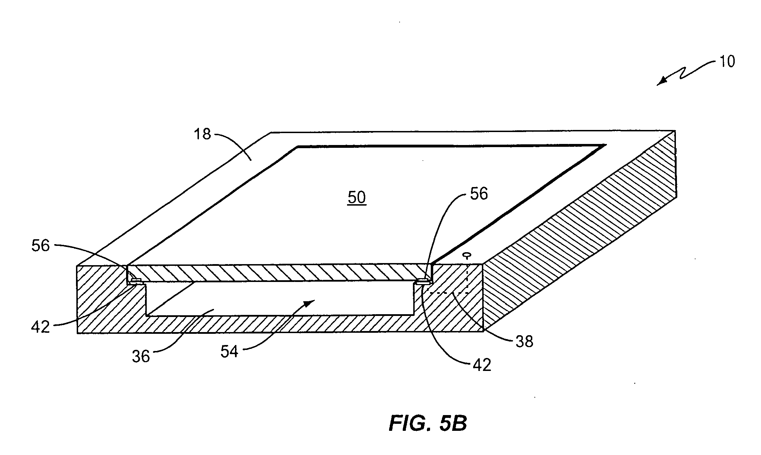

Figures 5A-5B illustrates another embodiment of the present invention that utilizes a different method for electrically bonding the module 50 into the cavity 30. Particularly, this embodiment uses a conductive adhesive such as Anisotropic Conductive Film (ACF) 42 disposed on the top surface of step 34. The ACF 42 is first deposited on the step 32. Then, the module 50 is placed on the step 34 such that electrical contacts 56 on the module 50 contact the ACF 42. The module 50 is then pressed into the ACF 42 such that the module 50 mounts to the cavity 30. To electrically connect the module 50, a high heat (e.g., 120-230°C) is applied to the ACF 42 for a predetermined time (e.g., 5-15 seconds). The high heat causes the ACF 42 to flow and bond with the electrical contacts 56 on the underside of the module 50. Once cured, the ACF 42 electrically connects the module 50 to the PWB assembly 10. As seen in Figure 5B, a gap 54 is formed between the floor 36 and the underside of the module 50.

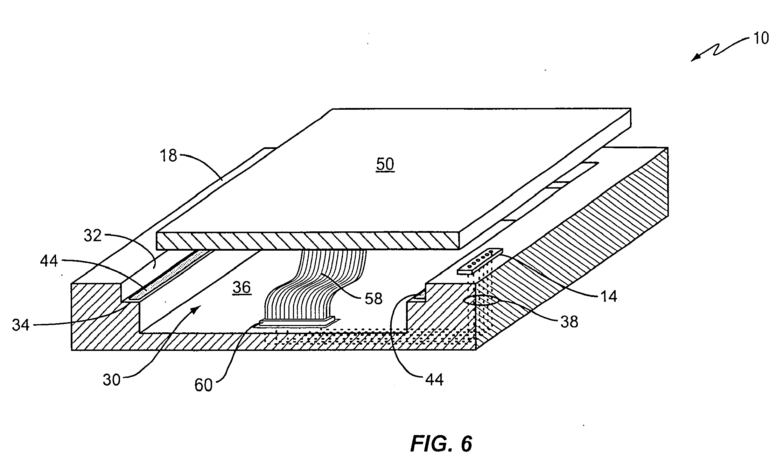

Figure 6 illustrates another embodiment wherein cavity 30 includes a connector 60 disposed on the surface of floor 36. As seen in Figure 6, the module 50 is bonded to the cavity 30 using a strip adhesive 44, which may or may not be conductive. A flex cable 58 connected to module 50 includes a plug that mates with connector 60 attached to the floor surface 36. In this embodiment, the conductive traces 38 electrically couple the connector 60 to connector 14 disposed on surface 18 of the PWB assembly 10. The connectors 14, 60 may be any connector known in the art. For example, the connectors 14, 60 in this embodiment are socket connectors. However, the present invention is not limited solely to the use of these types of connectors. In at least one embodiment, one or both of the connectors 14, 60 comprises a Bayonet Neill-Concelman (BNC) type RF connector.

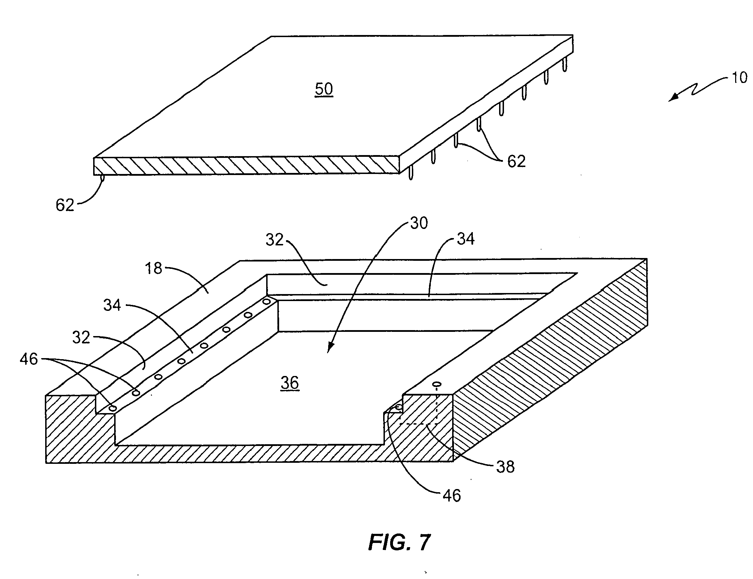

Figure 7 illustrates another embodiment wherein the step 34 includes a plurality of sockets 46. Each socket 46 is conductive and is connected to a corresponding trace 38. The traces 38, as stated above, extend through the assembly 10 and terminate at another conductive pad disposed on surface 18 of the PWB assembly 10. The module 50 in this embodiment comprises a pin grid array (PGA) 62 disposed on its bottom surface. Each pin in the array 62 corresponds to one of the sockets 46. To connect the module 50 to the cavity 30, the pins in the array 62 are first aligned with their corresponding sockets 46. Then, a slight pressure may be exerted on the module 50 to cause each pin in the array 60 to enter its corresponding socket 46 and make an electrical connection to the PWB assembly 10.

The embodiments of Figure 6 and 7 provide an additional benefit in that both allow for the module 50 to be changed as needed. For example, a first module 50 may be removed from within cavity 30 and replaced with a second upgraded module 50 that adds functions and/or that has corrected software. This interchangeability of electronic components on the PWB assembly 10 facilitates a "plug-n-play" approach to upgrading modules 50.

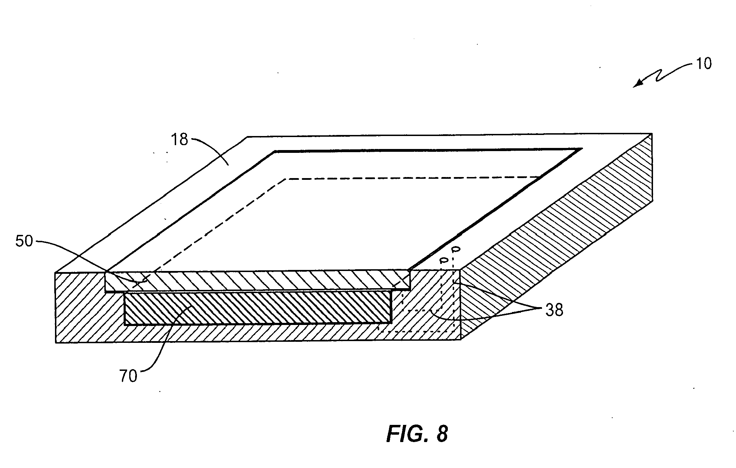

Figure 8 illustrates another embodiment wherein cavity 30 is sized to receive more than one electronic component. As seen in the previous embodiments, the first module 50 is supported by and electrically connected to the step 34. In addition, a second module 70 is disposed on the floor 36 such that it fits under the first module 50. In these cases, both modules 50 and 70 may be electrically connected to other parts of the PWB assembly 10 via one or more conductive traces 38.

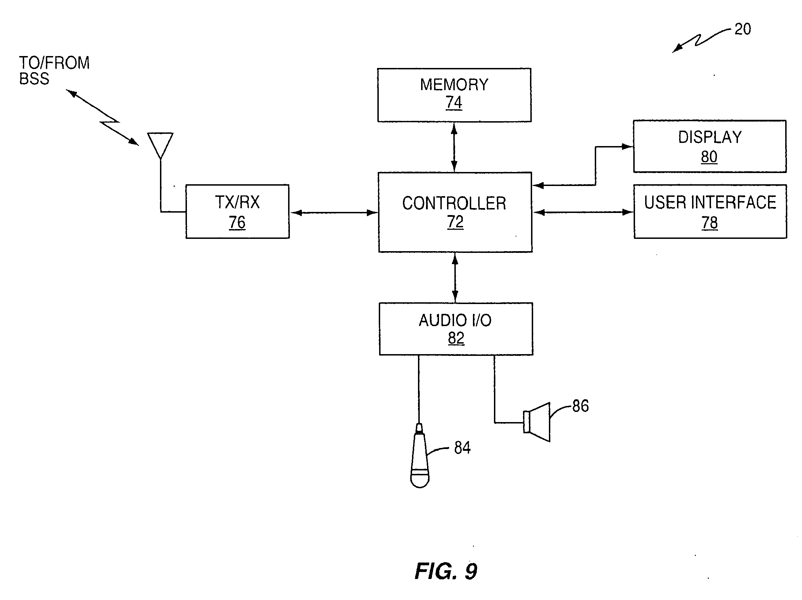

Figure 9 is a block diagram illustrating some exemplary components of the cellular telephone 20 configured according to one embodiment of the present invention. The circuitry for any of these components may be contained in a module, such as module 50, for example, and electrically connected to cavity 30 in the PWB assembly 10.

As seen in Figure 9, the cellular telephone 20 comprises a main controller 72 to control the overall operation of the cellular telephone 20 and to execute user applications. Memory 74 stores those applications, system data needed for operation, and user data. The cellular telephone 20 further includes one or more communication interfaces 76 for communicating with remote devices over various communication networks. The communication interfaces 76, which may implement module 50, may be, for example, a conventional cellular transceiver that uses any known access technology, including, but not limited to, General Packet Radio Service (GPRS), Wideband Code Division Multiple Access (WCDMA), and Orthogonal Frequency-Division Multiplexing (OFDM).

The cellular telephone 20 further comprises a user interface 78 and a display 80. Display 80 outputs information for viewing by the user and the user interface 78 receives the user's input. The user interface 78 may comprise, for example, a keyboard, keypad, scroll wheel, touch pad, trackball, or other suitable user input device. A touch screen display may also be used as an input device.

Cellular telephone 20 also includes an audio processing unit 82 that processes audio signals. Specifically, a microphone 84 converts audible sounds into audio data for input to the audio processing unit 82. Those signals may then be sent to one or more remote parties via communication interface 76. A speaker 86 converts audio signals output by the audio processing unit 82 into audible sound that the user can hear.

The present invention may, of course, be carried out in other ways than those specifically set forth herein without departing from essential characteristics of the invention. For example, the PWB assembly 10 is not limited to use in a portable electronic device such as cellular telephone 20, but rather, can be employed in any electronic device that uses PWBs. Therefore, the present embodiments are to be considered in all respects as illustrative and not restrictive, and all changes coming within the meaning and equivalency range of the appended claims are intended to be embraced therein.

## Claims

1. A Printed Wiring Board (PWB) (10) comprising:
a generally planar top surface (18) configured to receive electronic components (12, 14, 16); and
a dual-height cavity (30) formed in the top surface (18) of the PWB (10) and sized to receive a first electronic component (50), the dual-height cavity (30) comprising:
a sidewall (32) and a floor surface (36);
a step (34) formed within the dual-height cavity (30) and along the sidewall (32); and
an electrical connection (38; 40; 42; 46; 14, 58, 60) formed within the dual-height cavity (30), and configured to electrically connect the first electronic component (50) to one or more of the electronic components (12, 14, 16) mounted on the top surface (18).

2. The PWB (10) of claim 1 wherein the electrical connection comprises an array of conductive pads (40) formed on a surface of the step (34).

3. The PWB (10) of claim 1 or claim 2 wherein the electrical connection comprises a conductive adhesive (42) disposed on a surface of the step (34).

4. The PWB (10) of any one of claims 1-3 wherein the electrical connection comprises a connector (46) disposed on a surface of the step (34).

5. The PWB (10) of any one of claims 1-4 wherein the electrical connection comprises a conductive pathway (38; 58) extending through the interior of the PWB (10) to the one or more electronic components (12, 14, 16) mounted on the top surface (18).

6. The PWB (10) of any one of claims 2-5 wherein a top surface of the first electronic component (50) lies generally within the same plane as the top surface (18) of the PWB (10) when the first component (50) is mounted to the step (34) within the dual-height cavity (30).

7. The PWB (10) of any one of claims 2-6 further comprising a gap (54) formed between the first electronic component (50) and the floor surface (36) when the first component (50) is mounted to the step (34) within the dual-height cavity (30).

8. The PWB (10) of claim 7 wherein the electrical connection comprises a connector (60) disposed on the floor surface (36) of the dual-height cavity (30) within the gap (54).

9. The PWB (10) of any one of claims 1-8 wherein the electrical connection comprises a first electrical connection (14, 38) formed on a surface of the step (34), and further comprising a second electrical connection (60, 38) disposed on the floor surface of the dual-height cavity (30).

10. The PWB (10) of claim 9 wherein the second electrical connection (38) is configured to electrically connect a second electronic component (70) mounted within the dual-height cavity (30) to the PWB (10).

11. The PWB (10) of any one of claims 1-10 wherein the step (34) has a height that is between the top surface (18) of the PWB (10) and the floor surface (36) of the dual-height cavity (30).

12. A method of mounting electronic components to a Printed Wiring Board (PWB) (10) having a top surface (18) for mounting electronic components (12, 14, 16), the method comprising:
mounting a first electronic component (50) within a dual-height stepped cavity (30) formed as a recess in the top surface (18) of the PWB (10); and
electrically connecting the first electronic component (50) to the PWB (10) via a first electrical contact (38; 40; 42; 46; 14, 58, 60) disposed within the dual-height cavity (30).

13. The method of claim 12 wherein electrically connecting the first electronic component (50) to the PWB (10) comprises electrically connecting the first electronic component (50) to one or more electronic components (12, 14, 16) mounted on the top surface (18) of the PWB (10) via a first conductive path extending through the interior of the PWB (10) between the first electrical contact ( 38; 40; 42; 46; 14, 58, 60) and the top surface (18) of the PWB (10).

14. The method of claim 13 further comprising electrically connecting a second electronic component (70) to the PWB (10) via a second electrical contact (38) disposed within the dual-height cavity (30).

15. A wireless communication device (20) comprising:
a housing;
a transceiver module (76) to communicate wireless signals to, and receive wireless signals from, a base station in a wireless communication network; and
a Printed Wiring Board (PWB) (10) according to any one of claims 1-11, wherein the PWB (10) is disposed within the housing.
